# EUROPEAN PATENT APPLICATION

(11) **EP 2 618 485 A1**
(43) Date of publication of application: **24.07.2013**
(21) Application number: 12197122.0
(22) Date of filing: 14.12.2012
(51) Int. Cl.: H03K 5/08, H03K 5/24

(54) **Multi-threshold comparison circuit**

(30) Priority: 20.01.2012 CN 201210019916
(71) Applicant: Siemens Aktiengesellschaft, 80333 München (DE)
(72) Inventor: Du, Feng, Dr., 200030 Shanghai (CN); Chen, Wei Gang, Dr., 200082 Shanghai (CN); Dankert, Mario, 06779 Raguhn-Jeßnitz (DE); Zhuo, Yue, 100084 Beijing (CN)

(57) **Abstract**

The present invention provides a multi-threshold comparison circuit comprising: a comparator (610) having a first input terminal (In), a second input terminal (Ref) and an output terminal (Out); N feedback branches (920-1, 920-2......920-n), each feedback branch being coupled between the second input terminal (Ref) and output terminal (Out) of the comparator (610) to form positive feedback, wherein N is an integer greater than 1; and a threshold switching circuit (930) coupled to at least one of the N feedback branches (920-1, 920-2......920-n), for selectively switching at least one of the multiple feedback branches on or off, so as to provide a plurality of different reference voltages at the second input terminal (Ref) of the comparator (610) at different times.

## Description

### Technical field

The present invention relates to a comparison circuit, in particular to a hysteresis comparison circuit.

### Background art

The comparison circuit is a basic circuit structure which is used widely in the electronics field. A comparison circuit generally compares two input signals (such as electric current or voltage), then outputs HIGH or LOW (for example) at the output terminal thereof to indicate which input signal is larger. The output of the comparison circuit may be used as the input for the next stage of logic. For example, in the field of automatic control, a comparison circuit may be used to detect whether an input signal is higher or lower than a preset threshold, and the output of the comparison circuit may be used for feedback control of the input signal.

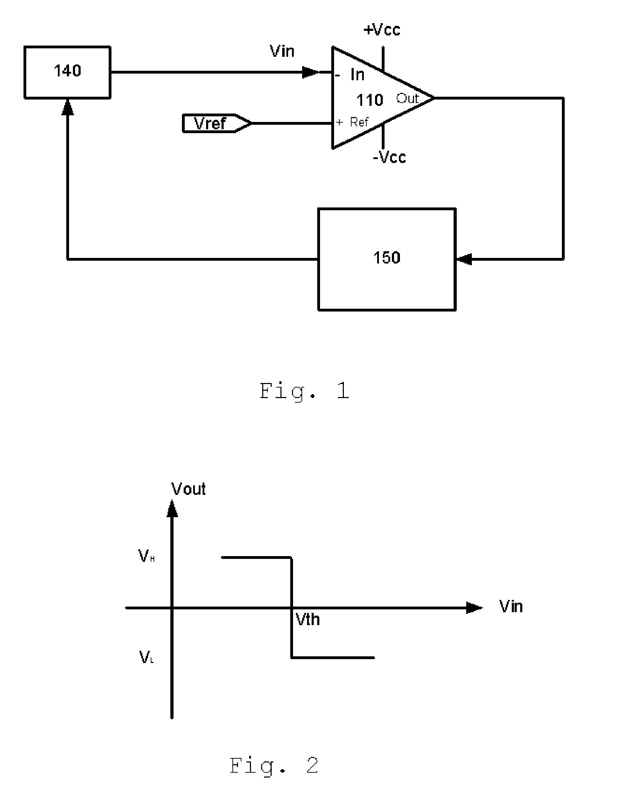

Fig. 1 shows an application in which the output of a comparison circuit is used for feedback control. In Fig. 1, the comparison circuit is formed by an op-amp (OP) 110. The inverting input (In) of OP 110 obtains an input voltage signal Vin from a monitoring module 140; this signal may represent a physical quantity actually detected such as temperature, humidity, current, the derivative of current or voltage, etc. The non-inverting input (Ref) of OP 110 is connected to a fixed reference voltage Vref, which may also be referred to as the threshold voltage Vth. Suppose the Vin received represents temperature and is greater than Vref; OP will then output a low level V_{L}, indicating that the current temperature has exceeded the threshold. The low level V_{L} can in turn be inputted into a feedback control circuit 150 as a feedback signal. The feedback control circuit 150 performs an operation in response to the V_{L}, for instance, lowers the heating power so as to lower the monitored temperature value. In contrast, if Vin is less than Vref, OP 110 outputs a high level V_{H}, and the feedback control circuit 150 increases the heating power in response to the high level V_{H}. The threshold waveform diagram for the comparison circuit in Fig. 1 is shown in Fig. 2. When Vin is very close to the threshold Vref (Vth), that is, Vin fluctuates up and down near the threshold, the feedback control process shown in Fig. 1 will enter an unstable state, for instance, switch rapidly between increasing and lowering the heating power, and there is a possibility that damage to associated devices will result.

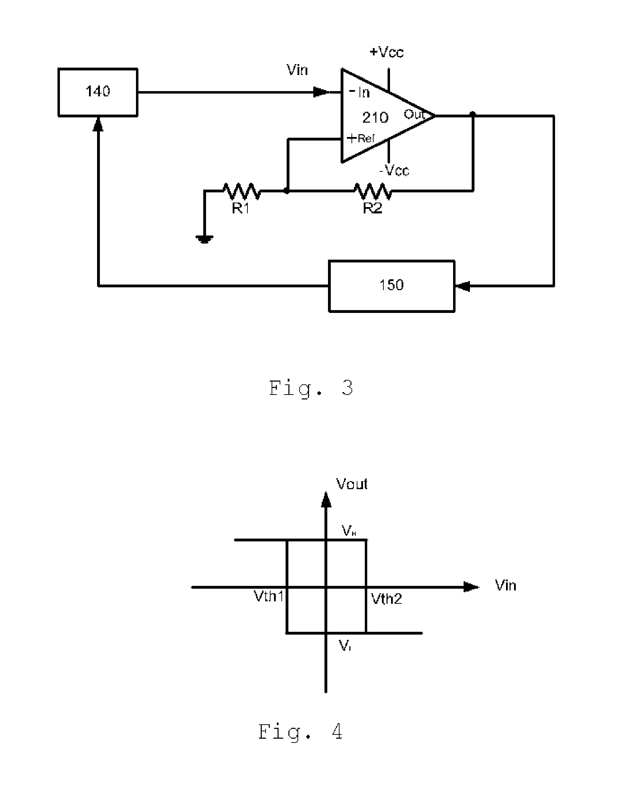

In order to overcome the above problem, a hysteresis comparison circuit as shown in Fig. 3 has been proposed. This is different from Fig. 1 in that the comparison circuit shown in Fig. 3 is formed by an OP 210. The inverting input "-" of OP 210 receives an input signal Vin, while the non-inverting input "+" is connected to ground via a resistor R1 (or may also be connected to a fixed voltage). At the same time, a feedback resistor R2 is connected between the output Out and non-inverting input "+" of OP 210, forming positive feedback. In this way, the voltage value at the non-inverting input "+" of OP 210 can vary with the size of the output voltage Vout; the waveform thereof is shown in Fig. 4. Specifically, the hysteresis comparison circuit shown in Fig. 3 has two threshold voltages Vₜₕ₁ and Vₜₕ₂, where Vₜₕ₁ < Vₜₕ₂. When Vin is very small, Vout is high level V_{H}, and the feedback control 150 performs a corresponding operation to increase the size of the monitored physical quantity, that is, increases Vin; at this point, the threshold voltage Vₜₕ₂ = (R1*V_{H})/(R1+R2). When Vin rises above Vₜₕ₂, Vout is low level V_{L}, and the feedback control 150 performs a corresponding operation to reduce the value of Vin. At this point, owing to the change in Vout, the threshold voltage changes to Vₜₕ₁ = (R1*V_{L})/(R1+R2). Vout only changes to V_{H} when Vin falls below Vₜₕ₁. Thus, even if Vin fluctuates between Vₜₕ₁ and Vₜₕ₂, this will not cause the feedback control circuit 150 to switch rapidly back and forth, and so stability is improved.

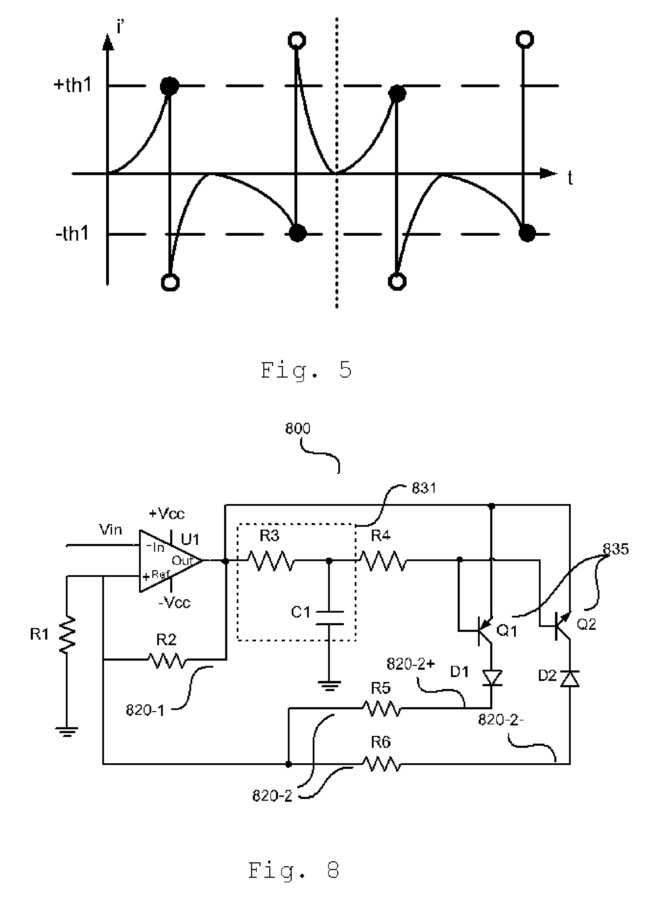

However, since there are only two comparison thresholds in the hysteresis comparison circuit shown in Fig. 3, the hysteresis comparison circuit shown in Fig. 3 cannot be used for applications requiring several thresholds in one signal cycle. Fig. 5 shows a waveform diagram of the derivative of the excitation current in a residual current detector. As Fig. 5 shows, four peak values occur in both the positive and negative directions. Depending on the actual situation, it is only necessary to switch the output of the comparison circuit at the peak value points marked with solid circles in order to suppress current growth or reduction, whereas switching must be avoided at the peak value points marked with empty circles. Faced with the situation shown in Fig. 5, the hysteresis comparator shown in Fig. 3 is obviously unable to meet the requirements.

For this reason, there exists a need in existing technology for a novel multi-threshold comparison circuit.

### Content of the invention

In view of the above shortcomings in existing technology, the embodiments of the present invention set forth a multi-threshold comparison circuit, which is able to provide multiple comparison thresholds and thereby able to switch the output of the comparison circuit at only one or more desired thresholds from among the multiple thresholds according to actual requirements.

According to one aspect of the present invention, the multi-threshold comparison circuit comprises: a comparator having a first input terminal, a second input terminal and an output terminal, the first input terminal receiving an input voltage and the second input terminal receiving a reference voltage, the output voltage of the output terminal being a first level when the first input terminal voltage is higher than the second input terminal voltage, and the output voltage being a second level when the first input terminal voltage is lower than the second input terminal voltage; N feedback branches, each feedback branch being coupled between the second input terminal and output terminal of the comparator to form positive feedback, wherein N is an integer greater than 1; and a threshold switching circuit coupled to at least one of the N feedback branches for selectively switching at least one of the multiple feedback branches on or off, so as to provide a plurality of different reference voltages at the second input terminal of the comparator at different times. Preferably, the comparator is an operational amplifier, the first input terminal being the inverting input of the operational amplifier and the second input terminal being the non-inverting input of the operational amplifier. Preferably, one or more of the N feedback branches contains a feedback resistor.

Using the above comparison circuit proposed in the present invention, those skilled in the art are able to conveniently and rationally select the number of feedback branches, the size of threshold given by each feedback branch, and the time to switch the output of the comparison circuit, based on the variation characteristics of the physical quantity actually being monitored.

In one embodiment of the present invention, the threshold switching circuit preferably comprises a control circuit and M switching elements, wherein M is an integer greater than or equal to 1, and M is less than or equal to N; each switching element is disposed on one of the N feedback branches, for switching on this feedback branch in response to an enable signal from the control circuit, or switching off this feedback branch in response to a disable signal from the control circuit; the control circuit is used for sending the enable control signal or disable control signal to at least one of the M switching elements at a specified time. Preferably, each of the M switching elements is any one of a bipolar junction transistor, field effect transistor or relay. The use of switching elements to switch different feedback branches results in a simple structure, convenient operation and easy implementation.

Preferably, one end of the control circuit is coupled to the output terminal of the comparator, for generating the enable signal or disable signal in response to switching of the output terminal voltage. Preferably, a timing control circuit is used for switching at least one of the M switching elements on or off at a predetermined time. Preferably, the control circuit is a timing control circuit, for sending the enable signal or disable signal to at least one of the M switching elements at a timed start or end time. Even more preferably, the timing control circuit is an RC timing circuit.

Using a timing control circuit enables the size of threshold of the comparison circuit proposed in the present invention to be conveniently switched when a predetermined time expires. Moreover, when the control circuit is connected to the comparator output, the comparison circuit proposed in the present invention is also capable of automatic or adaptive threshold switching. Preferably, the timing control circuit is an RC timing circuit.

Preferably, the feedback branches comprise a first feedback branch and a second feedback branch, and a first switching element is disposed on the second feedback branch. Even more preferably, one or more of the N feedback branches comprises a positive feedback branch used for a positive half-cycle of the comparator output voltage, and a negative feedback branch used for a negative half-cycle of the comparator output voltage.

Even more preferably, the feedback branches comprise a first feedback branch and a second feedback branch, and a second switching element is disposed on the second feedback branch. The second feedback branch further comprises a positive second feedback branch and a negative second feedback branch, and the second switching element further comprises a first transistor Q1 for the positive second feedback branch and a second transistor Q2 for the negative second feedback branch, wherein the first transistor Q1 is used for switching on the positive second feedback branch in response to an enable control signal from the control circuit, and switching off the positive second feedback branch in response to a disable signal from the control circuit, when the output terminal of the comparator switches from the first level to the second level; and the second transistor Q2 is used for switching on the negative second feedback branch in response to an enable control signal from the control circuit, and switching off the negative second feedback branch in response to a disable signal from the control circuit, when the output terminal of the comparator switches from the second level to the first level.

### Description of the accompanying drawings

The object, characteristics, features and advantages of the present invention will become more obvious in the course of the following detailed description which refers to the accompanying drawings, in which:
Fig. 1 and Fig. 2 show a feedback control application of an existing comparison circuit and the threshold waveform thereof, respectively;
Fig. 3 and Fig. 4 show a feedback control application of an existing hysteresis comparison circuit and the threshold waveform thereof;
Fig. 5 shows a waveform diagram of an excitation current derivative having multiple peak values;
Fig. 6 and Fig. 7 show a comparison circuit structure according to an embodiment of the present invention and the threshold waveform thereof, respectively;
Fig. 8 shows a detailed circuit diagram of the comparison circuit shown in Fig. 6;
Fig. 9 and Fig. 10 show a comparison circuit structure according to another embodiment of the present invention and the threshold waveform thereof, respectively.

### Particular embodiments

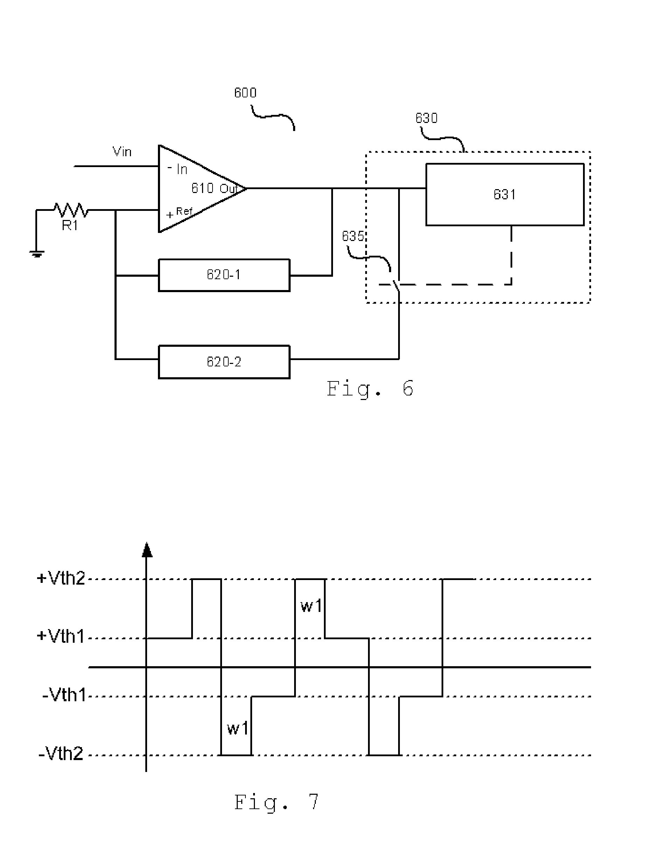

In view of the current demand for multi-threshold comparators, the present invention proposes a multi-threshold comparison circuit. Fig. 6 shows by way of example a block diagram of a multi-threshold comparison circuit 600 according to an embodiment of the present invention. As Fig. 6 shows, the comparison circuit 600 comprises a comparator 610, two feedback branches 620-1 and 620-2, and a threshold switching circuit 630, wherein the threshold switching circuit 630 preferably may comprise a control circuit 631 and a switching element 635. In the example shown in Fig. 6, the control circuit 631 is preferably a timing control circuit, and referred to below as the timing control circuit 631.

Specifically, as shown in Fig. 6, the comparator 610 may be formed by an op-amp, the inverting input "-" (In) of the op-amp being used for receiving an external input signal Vin, and the non-inverting input "+" (Ref) thereof being used for receiving a reference voltage Vref or Vth that is to be compared with Vin; the output terminal Out of the op-amp outputs the comparison result, for example HIGH or LOW. Other structures may also of course be employed for the comparator 610 according to actual requirements; for example, the comparator may also be formed using bipolar junction transistors or field effect transistors, and this will be obvious to those skilled in the art.

The two feedback branches 620-1 and 620-2 are both coupled between the non-inverting input Ref and output terminal Out of the comparator 610 to form two positive feedback paths. In the example shown in Fig. 6, each of these two feedback branches is similar to the feedback resistor R2 in Fig. 3, being used for feeding Vout back to the non-inverting input of the comparator 610 so as to form a hysteresis comparison circuit. The difference lies in the fact that a switching element 635 is also provided on the second feedback branch 620-2. The switching element 635 is a controlled switching element, used for switching the second feedback branch on or off in response to a received enable or disable control signal, that is, for breaking the electrical connection to the output terminal Out of the comparator 610. In this way, the comparison circuit 600 shown in Fig. 6 can provide a first threshold Vₜₕ₁ pair capable of realizing hysteresis comparison when the second feedback branch 620-2 is ineffective (that is, only the first feedback branch is effective), and provide a second threshold Vₜₕ₂ pair capable of realizing hysteresis comparison when the second feedback branch 620-2 is effective (that is, the first and second feedback branches are connected in parallel). Since the first feedback branch 620-1 is always effective, the amplitude of Vₜₕ₂ obtained when the first and second feedback branches are both effective is greater than that of Vₜₕ₁. The first and second feedback branches 620-1 and 620-2 may for example comprise feedback resistors, the resistance of which may be selected according to actual requirements. However, the first and second feedback branches may also be implemented as other circuit structures according to the actual situation. For example, the feedback branch may also be a conductive wire.

The threshold switching circuit 630 shown in the example shown in Fig. 6 also comprises a timing control circuit 631 connected to the output terminal Out of the comparator 610, for controlling when the switching element 635 switches on and when it switches off. Specifically, for example, the switching element 635 is switched off at the start, only the first feedback branch 620-1 is effective, and the threshold pair used for hysteresis comparison is +Vₜₕ₁ and -Vₜₕ₁. When Vin is greater than +Vₜₕ₁, Vout changes from, for example, V_{H} to V_{L}, so as to reduce Vin. At this point, the timing control circuit 631 can begin counting and switch on the switching element 635 (emit an enable signal) in response to the falling edge of Vout, such that the threshold voltage at the Ref end of the comparator 610 is -Vₜₕ₂, thereby increasing the amplitude of the threshold. Once a predetermined time period w1 expires, the timing control circuit 631 switches off the switching element 635 (emits a disable signal), so that the threshold voltage Vref returns to -Vₜₕ₁. It is a similar situation during the positive half-cycle. When Vin is less than -Vₜₕ₁, Vout changes from, for example, V_{L} to V_{H}, so as to increase Vin. At this point, the timing control circuit 631 can begin counting and switch on the switching element 635 in response to the rising edge of Vout, such that the threshold voltage at the Ref end of the comparator 610 is +Vₜₕ₂. Once a predetermined time period w1 expires, the timing control circuit 631 switches off the switching element 635, so that the threshold voltage Vref returns to +Vₜₕ₁. In this way, the threshold waveform diagram shown in Fig. 7 is obtained.

It can be seen from Fig. 7 that even if Vin were to become less than -Vₜₕ₁ or greater than +Vₜₕ₁ within the time period w1, this would not cause the output of the comparator 610 to toggle. Thus, by using the multi-threshold comparison circuit 600 shown in Fig. 6, the application requirements of the current derivative shown in Fig. 5 can be met. Those skilled in the art can flexibly control the switching time of different thresholds (at a rising edge or falling edge of Vout, or in response to a clock signal inputted externally), and the duration w1 thereof, according to the variation pattern of the physical quantity actually being monitored, and flexibly determine the size of the threshold by configuring different feedback resistances.

Fig. 8 shows a detailed circuit diagram of the block diagram shown in Fig. 6. As Fig. 8 shows, the comparator U1 is still implemented using an op-amp. First and second feedback branches 820-1 and 820-2 are formed by feedback resistors. The difference lies in the fact that the second feedback branch specifically comprises positive and negative second feedback branches 820-2+ and 820-2-, used for positive and negative half-cycles, respectively. Correspondingly, a second switching element 835 used for the second feedback branch 820-2 also specifically comprises transistors which are disposed between the positive second feedback branch and the output terminal Out of the comparator U1, and between the negative second feedback branch and the output terminal Out of the comparator U1, respectively. Moreover, an RC timing circuit (R3 and C1) is used as a control circuit 831, the output terminal thereof controlling the base of each transistor, so as to decide when each transistor switches on and when it switches off.

Specifically, in Fig. 8, the inverting input "-" of the comparator U1 receives an input signal Vin, while the non-inverting input "+" is the reference voltage input terminal Ref, connected to ground through a resistor R1. The first feedback branch 820-1 is formed by a feedback resistor R2, which is connected between the non-inverting input "+" and output terminal Out of the comparator U1. The second feedback branch 820-2 comprises two feedback resistors R5 and R6, used for positive and negative half-cycles, respectively; in this embodiment, R5 and R6 have the same resistance. However, in practical applications, it is also possible for R5 and R6 to have different resistances, so as to obtain asymmetric thresholds. The positive and negative second feedback branches are each connected to a transistor (Q1 or Q2) used as a switching element. Q1 is a PNP transistor, used for positive half-cycles; the collector thereof is connected to the feedback resistor R5, the emitter is connected to the output terminal Out of the comparator U1, and the base is connected through a biasing resistor R4 to the output terminal of the RC timing circuit, that is, to a capacitor C1. Q2 is an NPN transistor, used for negative half-cycles; the collector thereof is connected to the feedback resistor R6, the emitter is connected to the output terminal Out of the comparator U1, and the base is connected through a biasing resistor R4 to the output terminal of the RC timing circuit. In addition, to prevent back-flow of electric current, diodes D1 and D2 which conduct in only one direction are also disposed on each of the second feedback branches.

In Fig. 8, when the voltage across C1 is within the interval [V_{H} - 0.7 V, V_{L} + 0.7 V] (0.7 V being the conducting voltage drop for a diode), Q1 and Q2 are both switched off, causing disconnection of both second feedback branches. At this time, only the feedback resistor R2 is effective, therefore the threshold pair used for hysteresis comparison is +Vₜₕ₁ and -Vₜₕ₁. When Vout changes from V_{H} to V_{L}, Q2 conducts while Q1 is switched off during the RC charge/discharge period w1, because the voltage across C1 is higher than V_{L} + 0.7 V (0.7 V being the conducting voltage drop for a diode). As a result, during the charge/discharge period w1, the two feedback branches in which R2 and R6 are located are both effective, that is, R2 and R6 are connected in parallel, so that the non-inverting input (Ref) value of the comparator U1 changes to -Vₜₕ₂, as shown in Fig. 7. When the capacitor C1 discharges to V_{L} + 0.7 V, Q2 switches off, and Q1 is also switched off. At this point, the situation in which only the feedback resistor R2 is effective occurs again, in other words, Vref changes to -Vₜₕ₁, as shown in Fig. 7. When Vout changes from V_{L} to V_{H}, Q1 conducts while Q2 is switched off during the RC charge/discharge period w1, because the voltage across C1 is lower than V_{H} - 0.7 V. As a result, during the charge/discharge period w1, the two feedback branches in which R2 and R5 are located are both effective, that is, R2 and R5 are connected in parallel, so that the non-inverting input (Ref) value of the comparator U1 changes to +Vₜₕ₂, as shown in Fig. 7. When the capacitor C1 charges to V_{H} - 0.7 V, Q1 switches off, and Q2 is also switched off. At this point, the situation in which only the feedback resistor R2 is effective occurs again, in other words, Vref changes to +Vₜₕ₁, as shown in Fig. 7.

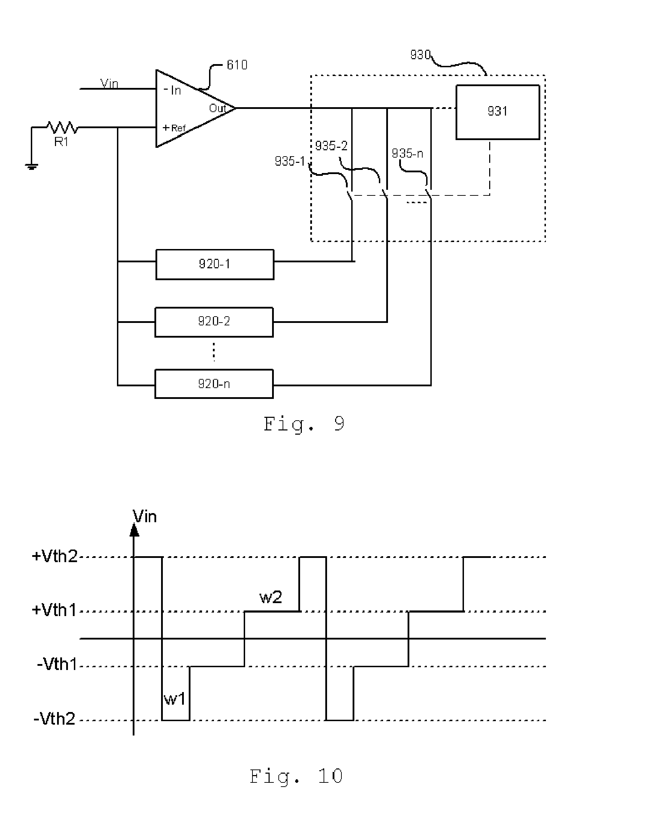

Thus, by using the circuit structure shown in Fig. 8, it is possible to obtain a comparison circuit having four thresholds, and switching of the comparison circuit output can be made to take place at the desired thresholds according to actual requirements. In the circuits shown in Fig. 6 and Fig. 8, the first feedback branch is always effective. However, this is not a requirement, and in practical applications, the effective feedback circuit may be selected flexibly, such as in the example shown in Fig. 9. In addition, in the examples shown in Fig. 6 and Fig. 8, the control circuits are connected to the output terminal of the comparator, constituting automatic threshold adjustment, but this is similarly not a requirement. In practical applications, the control circuit may also switch thresholds in direct response to an external input. This is similarly shown in Fig. 9.

Fig. 9 shows a multi-threshold comparison circuit according to another embodiment of the present invention. The structure shown in Fig. 9 is similar to the situation shown in Fig. 6, the difference being that the comparison circuit 900 in Fig. 9 comprises a plurality of feedback branches 920-1, 920-2 up to 920-n. A threshold switching circuit 930 comprises a switch 935-1, 935-2 up to 935-n disposed on each feedback branch (for example on the connection to the output terminal Out of the comparator 610), and a control circuit 931. These switching elements are all controlled by the timing control circuit 931.

In the example shown in Fig. 9, the timing control circuit 931 can flexibly switch the various feedback branches at different times according to actual requirements, so as to obtain at least n different thresholds. For example, if only the first feedback branch 920-1 is effective, the thresholds are +Vₜₕ₁ and -Vₜₕ₁; if only the nth feedback branch is effective, the thresholds are +Vₜₕₙ and -Vₜₕₙ. The timing control circuit 931 can control the duration of each threshold and the threshold switching time. Specifically, for example, the timing control circuit 931 can begin counting at a specified time (a falling edge of Vout, or a clock signal obtained from outside are possibilities) and switch each switching element, such that only the first feedback branch is connected to Vout, that is, Vref = Vₜₕ₁. Subsequently, once a first predetermined time period w1 expires, the timing control circuit 931 performs switching such that only the nth feedback branch is effective, that is, Vref = Vₜₕₙ. Subsequently, at a second specified time (the occurrence of a rising edge in Vout, or a clock signal obtained from outside are possibilities), the timing control circuit 931 begins counting again, and once a second predetermined time period w2 expires, performs switching such that only the first feedback branch is effective. An example of the specific threshold waveform is shown in Fig. 10.

In addition to the example shown in Fig. 10, the circuit structure given in Fig. 9 may also be configured as a comparison circuit having 8 or more thresholds. For instance, a comparison circuit with 8 thresholds may be implemented using 3 feedback branches; alternatively, a comparison circuit with 8 thresholds may be implemented using combinations of two feedback branches. It can thus be seen that by using, for example, the circuit structure shown in Fig. 9, those skilled in the art can switch the threshold of the comparison circuit at any time point, and the number of thresholds and the sizes thereof may be implemented through flexible configuration of the feedback branches. Thus, by using the circuit structure shown in Fig. 9, those skilled in the art can conveniently and rationally select the number of feedback branches, the size of threshold given by each feedback branch, and the timing requirements of the timing control circuit, based on the variation characteristics of the physical quantity actually being monitored.

In addition, the threshold switching circuits in the comparison circuits shown in Figs. 6, 8 and 9 all comprise a timing control circuit. However, in practical applications it is possible to omit the timing function and generate control signals directly on the basis of other external signals, to switch the switching elements on or off. For instance, control signals may be emitted by an external MCU (microcontroller) to control the switching elements. This will also be obvious to those skilled in the art. Furthermore, in all of the above examples, switching elements were used to switch the various feedback branches, but this is not a requirement. Those skilled in the art could also choose other ways of making one or more of the feedback branches cease to be effective according to actual requirements.

Those skilled in the art should understand that various changes and amendments may be made to the various embodiments disclosed above without departing from the substance of the present invention, and all such changes and amendments should fall within the scope of protection of the present invention. Therefore the scope of protection of the present invention should be defined by the attached claims.

## Claims

1. A multi-threshold comparison circuit, comprising:
a comparator (610) having a first input terminal (In), a second input terminal (Ref) and an output terminal (Out), the first input terminal (In) receiving an input voltage (Vin) and the second input terminal (Ref) receiving a reference voltage (Vref), the output voltage (Vout) of the output terminal (Out) being a first level when the first input terminal voltage (Vin) is higher than the second input terminal voltage (Vref), and the output voltage (Vout) being a second level when the first input terminal voltage (Vin) is lower than the second input terminal voltage (Vref);
N feedback branches (620-1, 620-2, 920-1, 920-2......920-n), each feedback branch being coupled between the second input terminal (Ref) and output terminal (Out) of the comparator (610) to form positive feedback, wherein N is an integer greater than 1; and
a threshold switching circuit (630, 930) coupled to at least one (620-2, 920-1, 920-2......920-n) of the N feedback branches for selectively switching at least one of the multiple feedback branches on or off, so as to provide a plurality of different reference voltages at the second input terminal (Ref) of the comparator (610) at different times.

2. The comparison circuit as claimed in claim 1, wherein the comparator (610) is an operational amplifier, the first input terminal (In) being the inverting input of the operational amplifier and the second input terminal (Ref) being the non-inverting input of the operational amplifier.

3. The comparison circuit as claimed in claim 1, wherein the threshold switching circuit (630, 930) comprises a control circuit (631, 931) and M switching elements (635, 935-1, 935-2......935-n), wherein M is an integer greater than or equal to 1, and M is less than or equal to N;
each switching element is disposed on one (620-2, 920-1, 920-2......920-n) of the N feedback branches, for switching on this feedback branch in response to an enable signal from the control circuit (631, 931), or switching off this feedback branch in response to a disable signal from the control circuit (631, 931); and
the control circuit (631, 931) is used for sending the enable control signal or disable control signal to at least one of the M switching elements (635, 935-1, 935-2......935-n) at a specified time.

4. The comparison circuit as claimed in claim 3, wherein one end of the control circuit (631, 931) is coupled to the output terminal (Out) of the comparator (610), for generating the enable signal or disable signal in response to switching of the output terminal voltage (Vout).

5. The comparison circuit as claimed in claim 3 or 4, wherein the control circuit (631, 931) is a timing control circuit, for sending the enable signal or disable signal to at least one of the M switching elements at a timed start or end time.

6. The comparison circuit as claimed in claim 5, wherein the timing control circuit is an RC timing circuit.

7. The comparison circuit as claimed in claim 3, wherein each of the M switching elements (635, 935-1, 935-2......935-n) is any one of a bipolar junction transistor, field effect transistor or relay.

8. The comparison circuit as claimed in claim 3, wherein N is 2, the feedback branches comprise a first feedback branch (620-1) and a second feedback branch (620-2), M is 1, and a first switching element (635) is disposed on the second feedback branch (620-2).

9. The comparison circuit as claimed in claim 4, wherein N is 2, the feedback branches comprise a first feedback branch (820-1) and a second feedback branch (820-2), M is 1, and a second switching element (835) is disposed on the second feedback branch (820-2);
the second feedback branch (820-2) further comprises a positive second feedback branch (820-2+) and a negative second feedback branch (820-2-),
and the second switching element (835) further comprises a first transistor (Q1) for the positive second feedback branch (820-2+) and a second transistor (Q2) for the negative second feedback branch (820-2-),
wherein the first transistor (Q1) is used for switching on the positive second feedback branch (820-2+) in response to an enable control signal from the control circuit (831), and switching off the positive second feedback branch (820-2+) in response to a disable signal from the control circuit (831), when the output terminal (Out) of the comparator (610) switches from the first level to the second level; and
the second transistor (Q2) is used for switching on the negative second feedback branch (820-2-) in response to an enable control signal from the control circuit (831), and switching off the negative second feedback branch (820-2-) in response to a disable signal from the control circuit (831), when the output terminal (Out) of the comparator (610) switches from the second level to the first level.

10. The comparison circuit as claimed in claim 1, wherein one or more of the N feedback branches comprises a feedback resistor (R2, R5, R6).

11. The comparison circuit as claimed in claim 1, wherein one or more of the N feedback branches comprises a positive feedback branch (820-2+) used for a positive half-cycle of the output voltage (Vout) of the comparator (610), and a negative feedback branch (820-2-) used for a negative half-cycle of the output voltage (Vout) of the comparator (610).
